(19) Europäisches Patentamt
European Patent Office
Office européen des brevets

(11) EP 1 158 683 A1

(12) **EUROPÄISCHE PATENTANMELDUNG**

(43) Veröffentlichungstag:
28.11.2001 Patentblatt 2001/48

(51) Int Cl.$^7$: **H03M 13/45**, G11B 20/10

(21) Anmeldenummer: 00111182.2

(22) Anmeldetag: 24.05.2000

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(71) Anmelder: **Infineon Technologies AG**
**81669 München (DE)**

(72) Erfinder:
• **Aymar, Peter**
**74379 Ingersheim (DE)**

• **Bohnhoff, Peter**
**81677 München (DE)**
• **Hartmann, Ralf**
**81377 München (DE)**

(74) Vertreter: **Viering, Jentschura & Partner**
**Steinsdorfstrasse 6**
**80538 München (DE)**

(54) **Vorrichtung und Verfahren zum Durchführen eines Viterbi-Algorithmus**

(57) Die Vorrichtung weist mehrere Anfangszustands-Register, mindestens ein Übergangs-Register sowie ein Addier/ Subtrahiernetzwerk auf. Weiterhin sind mehrere Auswerteeinheiten sowie eine Auswahleinheit vorgesehen, mit der zwischen einem ersten Betriebsmodus und einem zweiten Betriebsmodus der Vorrichtung umgeschaltet werden kann. Abhängig von dem gewählten Betriebsmodus sind durch die Auswahleinheit unterschiedliche Auswerteeinheiten auswählbar.

FIG 1

**Beschreibung**

Die Erfindung betrifft eine Vorrichtung sowie ein Verfahren zum Durchführen eines Viterbi-Algorithmus.

Eine solche Vorrichtung und ein solches Verfahren sind aus [1] bekannt.

Bei dem aus [1] bekannten Verfahren bzw. bei der aus [1] bekannten Vorrichtung wird ein empfangenes decodiertes Signal mittels einer elektrischen Schaltung, die gemäß einer sogenannten Butterfly-Struktur angeordnet ist, decodiert. Diese bekannte Vorgehensweise dient ausschließlich zum Kanaldecodieren von kanalencodierten Signalen.

Mit dieser Vorrichtung ist es nicht möglich, empfangene physikalische Signale mittels des Viterbi-Algorithmus zu entzerren.

Diese zusätzliche Option ist jedoch wünschenswert, um eine einfache, in verschiedenen Anwendungsgebieten ohne weiteres einsetzbare Vorrichtung zu erhalten, welche sich zum Durchführen des Viterbi-Algorithmus sowohl für ein Decodieren empfangener Signale als auch für ein Entzerren empfangener Signale eignet.

Aus [2] ist die Ermittlung einer sogenannten Übergangsmetrik für einen Viterbi-Algorithmus im Rahmen des Entzerrens physikalischer Signale für eine sogenannte Soft-Decision-Entzerrung bekannt. Weiterhin ist in [2] das gesamte Viterbi-Verfahren, angepasst auf die entsprechenden Übergangsmetriken für eine sogenannte Butterfly-Struktur einer Trellis und das Ermitteln der "optimalen" Symbolfolge der empfangenen Signale mittels der sogenannten Rückwärtsverfolgung (back-tracing) der ermittelten optimalen Trellis bekannt.

Nachteilig an der in [2] beschriebenen Vorgehensweise ist insbesondere, dass sich die dort beschriebene Schaltung lediglich zum Entzerren empfangener physikalischer Signale eignet. Diese Vorrichtung kann nicht zum Kanaldecodieren physikalischer Signale eingesetzt werden.

Grundlagen über den Viterbi-Algorithmus sind in [3] beschrieben.

Somit liegt der Erfindung das Problem zugrunde, einen Viterbi-Algorithmus flexibel durchführen zu können für unterschiedliche, auswählbare Betriebsmodi, beispielsweise zum Entzerren und zum Decodieren empfangener physikalischer Signale.

Das Problem wird mit der Vorrichtung sowie mit dem Verfahren zum Durchführen des Viterbi-Algorithmus mit den Merkmalen gemäß den unabhängigen Patentansprüchen gelöst.

Eine Vorrichtung zum Durchführen eines Viterbi-Algorithmus weist mehrere Anfangszustands-Register auf, in die jeweils eine Zustandsmetrik eines Anfangszustands einer Trellis speicherbar ist. In mindestens einem Übergangs-Register ist eine Übergangsmetrik der Trellis speicherbar. Weiterhin ist ein Addier-/Subtrahiernetzwerk vorgesehen, welches mit den Anfangszustands-Registern, dem Übergangs-Register und mit Auswerteeinheiten gemäß einer Butterfly-Struktur der Trellis verbunden sind, vorgesehen. In den Auswerteeinheiten werden die von dem Addier-/Subtrahiernetzwerk verarbeitete Signale gemäß dem Viterbi-Algorithmus ausgewertet. Weiterhin ist eine Auswahleinheit vorgesehen, in der zwischen einem ersten Betriebsmodus und einem zweiten Betriebsmodus der Vorrichtung umgeschaltet werden kann. Ferner weist die Vorrichtung Endzustands-Register auf, welche mit den Auswerteeinheiten gekoppelt sind. In die Endzustands-Register ist jeweils eine Zustandsmetrik eines Endzustands der Trellis speicherbar. Mit der Auswahleinheit sind unterschiedliche Auswerteeinheiten abhängig von dem gewählten Betriebsmodus auswählbar.

Bei einem Verfahren zum Durchführen eines Viterbi-Algorithmus wird in einem ersten Schritt ein Betriebsmodus aus einem ersten Betriebsmodus oder einem zweiten Betriebsmodus der Vorrichtung ausgewählt. Hierbei kann der erste Betriebsmodus ein Decodieren empfangener physikalischer Signal sein und ein zweiter Betriebsmodus ein Modus, in dem empfangene physikalische Signale entzerrt werden. In einem weiteren Schritt wird jeweils eine Zustandsmetrik eines Anfangszustands einer Trellis in jeweils ein Anfangszustands-Register gespeichert. Weiterhin wird mindestens eine Übergangsmetrik der Trellis gespeichert, abhängig von dem ausgewählten Betriebsmodus. Die Zustandsmetriken sowie die Übergangsmetrik werden miteinander gemäß einer Butterfly-Struktur der Trellis verknüpft gemäß dem Viterbi-Algorithmus und abhängig von dem ausgewählten Betriebsmodus. Die verknüpften Größen werden abhängig von dem ausgewählten Betriebsmodus ausgewählt und die ausgewählten verknüpften Größen werden als Zustandsmetrik eines jeweiligen Endzustands der Trellis gespeichert. Das Verfahren wird iterativ solange durchgeführt, bis der Viterbi-Algorithmus beendet worden ist.

Durch die Erfindung wird es erstmals möglich, einen Viterbi-Algorithmus für unterschiedliche Einsatzgebiete zu verwenden, beispielsweise zum Kanaldecodieren physikalischer Signale oder zum Entzerren physikalischer Signale.

Bevorzugte Weiterbildungen der Erfindung ergeben sich aus den abhängigen Ansprüchen.

Die Weiterbildungen der Erfindung betreffen sowohl das Verfahren als auch die Vorrichtung zum Durchführen des Viterbi-Algorithmus.

In der Vorrichtung kann mindestens eines der Anfangszustands-Register zusätzlich ein Pufferregister aufweisen.

Auf diese Weise wird es gemäß einer bevorzugten Ausgestaltung der Erfindung möglich, die jeweilige in dem Anfangszustands-Register gespeicherte Zustandsmetrik des Anfangszustands der Trellis in jeweils ein Pufferregister zu speichern, sobald ein Endzustand aus einem Endzustands-Register ausgelesen wird. In diesem Fall wird bevorzugt eine neue Zustandsmetrik eines Anfangszustands einer Trellis in jeweils ein Anfangszustands-Register gespeichert, sobald der jeweilige Anfangszustand der Trellis in dem Pufferregister gespeichert ist.

Ferner ist gemäß einer weiteren Ausgestaltung der Erfindung mindestens ein Übergangs-Register zum Speichern einer Übergangsmetrik vorgesehen, wenn die Vorrichtung in den ersten Betriebsmodus geschaltet ist, und/oder zum Speichern einer Änderungs-Übergangsmetrik, wenn die Vorrichtung in den zweiten Betriebsmodus geschaltet ist.

Gemäß dieser Ausgestaltung wird eine weitere Optimierung der Geschwindigkeit erreicht, mit der der Viterbi-Algorithmus ausgeführt werden kann, indem nicht mehr eine vollständige Übergangsmetrik im Rahmen des zweiten Betriebsmodus in einem Übergangs-Register gespeichert werden muss und das Übergangs-Register im Rahmen des anderen Betriebsmodus zum Speichern der Übergangsmetrik beim Decodieren der physikalischen Signale gemäß dem Viterbi-Algorithmus dient.

Somit wird nur ein Register zum Speichern für unterschiedliche Arten von Übergangsmetriken abhängig von dem jeweils ausgewählten Betriebsmodus bereitgestellt, was zu einer Verringerung des benötigten Bedarfs an Chipfläche bei der Realisierung der Vorrichtung als eine integrierte Schaltung in einem Chip führt.

Weiterhin wird durch die Weiterbildung eine Einsparung der Anzahl erforderlicher Speicherschritte und Schritte zum Umspeichern von Daten erreicht, was zu einer weiteren Optimierung des Viterbi-Algorithmus führt.

In einer weiteren Ausgestaltung der Erfindung ist es vorgesehen, mindestens zwei Übergangs-Register zum Speichern zweier unterschiedlicher Übergangsmetriken vorzusehen, wenn die Vorrichtung in den zweiten Betriebsmodus geschaltet ist. Insbesondere sind für die Vorrichtung für den zweiten Betriebsmodus vorzugsweise drei Übergangs-Register zum Speichern unterschiedlicher Übergangsmetriken vorgesehen, wobei in zwei Übergangs-Registern die jeweiligen Übergangsmetriken der Butterfly-Struktur des vorangegangenen Zustands gespeichert werden und in dem dritten Übergangs-Register eine Änderungs-Übergangsmetrik von dem vorangegangenen Zustand in den aktuell zu berechnenden Zustand.

In einer weiteren bevorzugten Ausgestaltung der Erfindung ist zumindest ein Teil der vorgesehenen Register in der Vorrichtung mit einem Prozessor mittels eines Signalbus gekoppelt.

Mit dieser Weiterbildung wird insbesondere bei Einsatz eines digitalen Signalprozessors dessen Prozessor im Rahmen der Trellisberechnung für den Viterbi-Algorithmus entlastet und somit kann der digitale Signalprozessor weitere Aufgaben übernehmen.

Vorzugsweise steuert der Prozessor das Speichern und Auslesen der einzelnen Anfangszustands-Register und der Endzustands-Register. Er berechnet weiterhin vorzugsweise die erforderlichen Übergangsmetriken sowie die Änderungs-Übergangsmetriken, und steuert auch das sogenannte Back-Tracing zum Ermitteln der aus stochastischer Sicht optimalen Empfangsfolge von Daten, die aus dem empfangenen physikalischen Signalen ermittelt werden sollen.

Weiterhin kann in der Vorrichtung ein Speicher, beispielsweise ein Random Access Memory (RAM), vorgesehen sein, der mit den Registern über den Signalbus gekoppelt ist. In dem Speicher werden vorzugsweise die erforderlichen Metriken sowie die Anfangszustände und Endzustände jeweils einer Trellis gemäß dem Viterbi-Algorithmus gespeichert.

In einer bevorzugten Ausführungsform der Erfindung sind in dem Addier-/Subtrahiernetzwerk mindestens ein Addier und/oder mindestens ein Subtrahierer vorgesehen, vorzugsweise drei Addierer und drei Subtrahierer, welche in folgender Weise miteinander gekoppelt sind:

- ein erster Eingang eines ersten Addierers mit dem Ausgang eines ersten Übergang-Registers gekoppelt ist,
- ein zweiter Eingang des ersten Addierers mit dem Ausgang eines zweiten Übergang-Registers gekoppelt ist,
- ein erster Eingang eines ersten Subtrahierers mit dem Ausgang des zweiten Übergang-Registers gekoppelt ist,
- ein zweiter Eingang des ersten Subtrahierers mit dem Ausgang eines dritten Übergang-Registers gekoppelt ist,
- ein erster Eingang eines zweiten Addierers mit dem Ausgang eines ersten Pufferregisters gekoppelt ist,
- ein zweiter Eingang des zweiten Addierers mit dem Ausgang des ersten Addierers gekoppelt ist,
- ein erster Eingang eines zweiten Subtrahierers mit dem Ausgang des ersten Pufferregisters gekoppelt ist,
- ein zweiter Eingang des zweiten Subtrahierers mit dem Ausgang des ersten Addierers gekoppelt ist,
- ein erster Eingang eines dritten Addierers mit dem Ausgang des ersten Subtrahierers gekoppelt ist,
- ein zweiter Eingang des dritten Addierers mit dem Ausgang eines zweiten Pufferregisters gekoppelt ist,
- ein erster Eingang eines dritten Subtrahierers mit dem Ausgang des ersten Subtrahierers gekoppelt ist,
- ein zweiter Eingang des dritten Subtrahierers mit dem Ausgang des zweiten Pufferregisters gekoppelt ist.

Die Auswerteeinheiten können ein Trace-Back-Register und/oder Vergleichseinheiten und/oder Maximum-Auswahlelemente aufweisen.

Ein Steuereingang eines Trace-Back-Registers kann mit einem Steuerausgang eines ersten Endzustands-Registers gekoppelt sein derart, dass bei Auslesen eines Wertes aus dem ersten Endzustands-Register das Trace-Back-Register neue Werte speichern kann. Ein erster Dateneingang des Trace-Back-Registers kann mit dem Ausgang eines ersten Vergleichers gekoppelt sein und ein zweiter Dateneingang des Trace-Back-Registers kann mit dem Ausgang eines zweiten Vergleichers gekoppelt sein.

Weiterhin kann ein erster Eingang eines ersten Vergleichers mit dem Ausgang des zweiten Addierers gekoppelt sein und ein zweiter Eingang des ersten Vergleichers kann mit dem Ausgang des dritten Subtrahierers gekoppelt sein. Ein erster Eingang eines zweiten Vergleichers kann mit dem Ausgang des zweiten Subtrahierers gekoppelt sein und ein zweiter Eingang des zweiten Vergleichers kann mit dem Ausgang des dritten Addierers gekoppelt sein.

In einer weiteren Ausgestaltung der Erfindung ist es vorgesehen, dass

- ein Steuereingang eines ersten Maximum-Auswahlelements mit dem Steuerausgang des ersten Endzustand-Registers gekoppelt ist derart, dass bei Auslesen eines Werts aus dem ersten Endzustand-Register das Maximum-Auswahlelements einen neuen Wert auswählen kann,
- ein erster Eingang des ersten Maximum-Auswahlelements mit dem Ausgang des zweiten Addierers gekoppelt ist,
- ein zweiter Eingang des ersten Maximum-Auswahlelements mit dem Ausgang des zweiten Subtrahierers gekoppelt ist,
- ein Steuereingang eines zweiten Maximum-Auswahlelements mit einem Steuerausgang eines zweiten Endzustand-Registers gekoppelt ist derart, dass bei Auslesen eines Werts aus dem zweiten Endzustand-Register das Maximum-Auswahlelements einen neuen Wert auswählen kann,
- ein erster Eingang des zweiten Maximum-Auswahlelements mit dem Ausgang des dritten Subtrahierers gekoppelt ist,
- ein zweiter Eingang des zweiten Maximum-Auswahlelements mit dem Ausgang des dritten Addierers gekoppelt ist.

Bevorzugt weist die Auswahleinheit Maximum-Auswahleinheiten sowie mindestens einen Multiplexer auf.

Gemäß einer weiteren Ausgestaltung der Erfindung ist vorgesehen, dass

- der Eingang des Auswahlregisters mit dem DSP-Bus gekoppelt ist,
- der Ausgang des Auswahlregisters mit einem Steuereingang eines ersten Multiplexers gekoppelt ist,
- ein erster Dateneingang des ersten Multiplexers mit einem ersten Datenausgang des Trace-Back-Registers gekoppelt ist,
- ein zweiter Dateneingang des ersten Multiplexers mit dem Ausgang des ersten Maximum-Auswahlelements gekoppelt ist,
- ein Steuereingang eines zweiten Multiplexers mit einem zweiten Datenausgang des Trace-Back-Registers gekoppelt ist,
- ein erster Dateneingang des zweiten Multiplexers mit dem Ausgang des zweiten Addierers gekoppelt ist,
- ein zweiter Dateneingang des zweiten Multiplexers mit dem Ausgang des dritten Subtrahierers gekoppelt ist,
- ein Steuereingang eines dritten Multiplexers mit einem dritten Datenausgang des Trace-Back-Registers gekoppelt ist,
- ein erster Dateneingang des dritten Multiplexers mit dem Ausgang des zweiten Subtrahierers gekoppelt ist,
- ein zweiter Dateneingang des dritten Multiplexers mit dem Ausgang des dritten Addierers gekoppelt ist.

Der erste Betriebsmodus ist bevorzugt ein Modus, in dem das Decodieren gemäß dem Viterbi-Algorithmus von empfangenen, verrauschten physikalischen Signalen durchgeführt wird. Der zweite Betriebsmodus kann ein Modus sein, in dem empfangene verrauschte physikalische Signale gemäß dem Viterbi-Algorithmus entzerrt werden.

Mit der oben beschriebenen Struktur ist eine hochoptimierte Vorrichtung zum Durchführen eines Viterbi-Algorithmus, beispielsweise zum Decodieren oder zum Entzerren empfangener, verrauschter physikalischer Signale geschaffen, die mit sehr wenigen Rechenschritten und Speicherschritten hinsichtlich der hohen Komplexität des Viterbi-Algorithmus auskommt.

Ein Ausführungsbeispiel der Erfindung ist in den Figuren dargestellt und wird im weiteren näher erläutert.

Es zeigen

Figur 1          eine elektrische Schaltung gemäß einem Ausführungsbeispiel der Erfindung;

Figur 2          ein Blockdiagramm, in dem das Senden, das Übertragen, und das Empfangen eines elektrischen Signals dargestellt ist;

Figuren 3a und 3b          eine Skizze, in der eine binäre Trellis gemäß einer Butterfly-Struktur dargestellt ist zum Entzerren (Figur 3a) bzw. für ein Decodieren (Fig. 3b) eines elektrischen Signals;

Figur 4 ein Blockschaltbild, das einen digitalen Signalprozessor gemäß einem Ausführungsbeispiel der Erfindung zeigt.

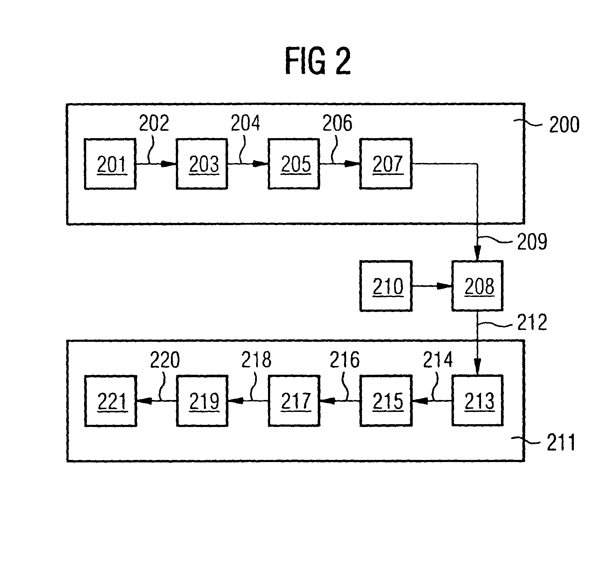

In **Fig.2** ist symbolisch eine Quelle 201 dargestellt, von der aus eine Nachricht 202 von einem Sender 200 zu einer Senke 221 in einem Empfänger 211 übertragen werden soll.

Die zu übertragende Nachricht 202 wird einem Quellencodierer 203 zugeführt, wo sie derart komprimiert wird, dass zwar keine Information verloren geht, aber für die Decodierung der Nachricht 202 überflüssige Redundanzinformation eliminiert wird und somit die benötigte Übertragungskapazität verringert wird.

Ausgabe des Quellencodierers 202 ist ein Codewort 204

$$\underline{u} \in \{\pm 1\}^k, \qquad\qquad (1)$$

das aus einer Folge digitaler Werte besteht. Dabei ist für jedes Codewort 204 $\underline{u}$ vorausgesetzt, dass jeder Wert $u_i$, i = 1, ..., k, des Codeworts 204 $\underline{u}$ mit gleicher Wahrscheinlichkeit einen ersten binären Wert (logisch "0") bzw. einen zweiten binären Wert (logisch "1") annimmt.

Das Codewort 204 $\underline{u}$ wird einer Einheit zur Kanalcodierung 205 zugeführt, in der eine Kanalcodierung des Codewortes 204 $\underline{u}$ erfolgt. Bei der Kanalcodierung wird dem Codewort 204 $\underline{u}$ gezielt Redundanzinformation hinzugefügt, um bei der Übertragung möglicherweise entstehende Übertragungsfehler korrigieren oder zumindest erkennen zu können, womit eine hohe Übertragungszuverlässigkeit erreicht wird.

Im weiteren wird davon ausgegangen, dass durch die Kanalcodierung jeden Codewort 204

$$\underline{u} \in \{\pm 1\}^k$$

ein Kanalcodewort 206

$$\underline{c} \in \{\pm 1\}^n, \qquad n > k, \qquad n \in N, \qquad\qquad (2)$$

zugeordnet wird.

Die Ausgabe der Einheit zur Kanalcodierung 205 besteht somit aus dem Kanalcodewort $\underline{c}$ 206.

Das Kanalcodewort $\underline{c}$ 206 wird einer Einheit zur Modulation 207 des Kanalcodewortes $\underline{c}$ 206 zugeführt.

Bei der Modulation wird dem Kanalcodewort $\underline{c}$ 206 eine für die Übertragung über einen physikalischen Kanal 208 geeignete Funktion

$$s : \mathfrak{R} \rightarrow \mathfrak{R}, \qquad\qquad (3)$$

zugeordnet.

Das zu übertragende modulierte Signal 209 enthält also sowohl Signalinformation, d.h. das Kanalcodewort $\underline{c}$ 206 als auch aus der Signalinformation ermittelte Redundanzinformation, d.h. zusätzlich die sogenannten Prüfwerte, die auch als Tailbits bezeichnet werden.

Das modulierte Signal s 209 wird über den physikalischen Kanal 208 zu einem Empfänger 211 übertragen. Bei der Übertragung über den physikalischen Kanal 208 tritt häufig eine Störung 210 auf, die das modulierte Signal 209 s verfälscht.

Somit liegt bei dem Empfänger 211 ein verändertes moduliertes Signal 212

$$\tilde{s} : \mathfrak{R} \rightarrow \mathfrak{R}, \qquad\qquad (4)$$

an, welches einer Einheit zur Demodulation 213 in dem Empfänger 211 zugeführt wird.

In der Einheit zur Demodulation 213 erfolgt eine Demodulation des veränderten modulierten Signals s 212. Ausgabe der Einheit zur Demodulation 213 ist ein im weiteren als elektrisches Signal 214 bezeichneter Vektor

$$\underline{y} \in \mathfrak{R}^n, \tag{5}$$

welcher das digitale, demodulierte veränderte Signal beschreibt.

Das elektrische Signal $\underline{y}$ 214 wird einer Einheit zum Entzerren des elektrischen Signals $\underline{y}$ 214 zugeführt, wo es einem im weiteren beschriebenen Viterbi-Algorithmus zum Entzerren des elektrischen Signals $\underline{y}$ 214 unterzogen wird. Vektorkomponenten $y_i$ des elektrischen Signals $\underline{y}$ 214 enthalten sowohl eine Vorzeicheninformation als auch eine Betragsinformation.

Die Betragsinformation ist jeweils der Absolutbetrag der Vektorkomponente $y_i$, der auch als Zuverlässigkeitsinformation für das entsprechende Vorzeichen der Vektorkomponente $y_i$ bezeichnet wird. Im Rahmen des Entzerrens des elektrischen Signals $\underline{y}$ 214 besteht die Aufgabe, eine sogenannte Soft-Decision-Entzerrung des elektrischen Signals durchführen.

Das von der Einheit zum Entzerren 215 des elektrischen Signals 214 gebildete entzerrte elektrische Signal 216 wird einer Einheit zur Kanaldecodierung 217 zugeführt.

Bei der Kanaldecodierung besteht die Aufgabe, eine sogenannte Soft-Decision-Decodierung durchzuführen. Dies bedeutet, dass ein rekonstruiertes Codewort rekonstruiert wird und ferner für jede Komponente eine Zuverlässigkeitsinformation ermittelt wird, dass die getroffene Entscheidung zur Rekonstruktion einer Komponente des rekonstruierten Codeworts beschreibt. Eine Komponente des rekonstruierten Codeworts 218 wird im weiteren als digitaler Signalwert bezeichnet.

Die Kanaldecodierung erfolgt ebenfalls mittels des Viterbi-Algorithmus, jedoch unter Verwendung gegenüber dem Viterbi-Algorithmus zum Entzerren des elektrischen Signals unterschiedlichen Übergangsmetriken.

Das rekonstruierte Codewort 218, d.h. mindestens ein digitaler Signalwert, wird einer Einheit zur Quellendecodierung 219 zugeführt, in der eine Quellendecodierung erfolgt. Das decodierte Signal 220 wird schließlich der Senke 221 zugeführt.

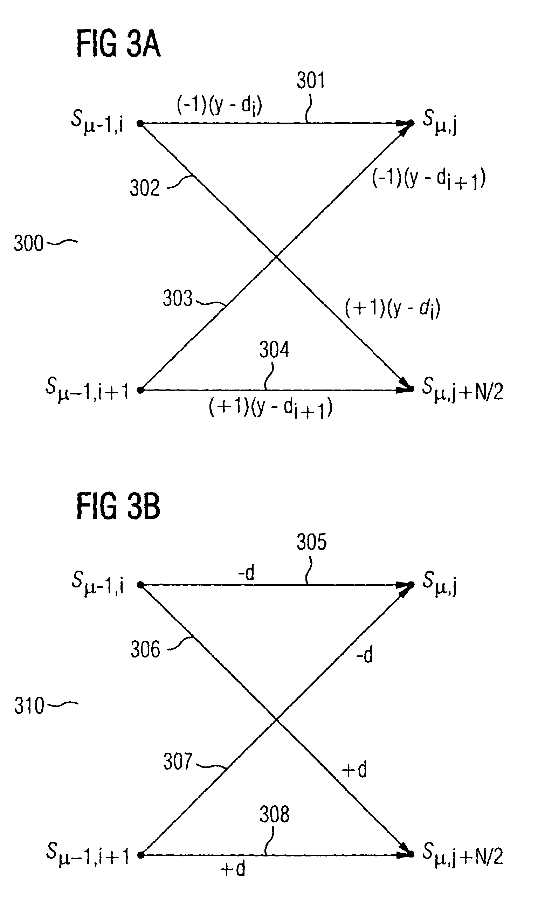

Im weiteren wird zum einfacheren Verständnis der Erfindung der Viterbi-Algorithmus in seiner Grobstruktur erläutert (vgl. **Fig.3a** und **Fig.3b).** Details über den Viterbi-Algorithmus sind in [3] beschrieben.

Im Rahmen dieses Ausführungsbeispiels wird von einem binär modulierten Signal ausgegangen, d.h. es bietet sich für die Durchführung des Viterbi-Algorithmus eine Trellis an, die mittels einer Butterfly-Struktur 300, wie sie in **Fig.3a** und **Fig.3b** dargestellt ist, implementiert werden kann.

Es wird gemäß der Trellis jeweils für zwei Anfangszustände

$$S_{\mu-1,i}, \tag{6}$$

$$S_{\mu-1,i+1}, \tag{7}$$

wobei mit

- $\mu$ eine Zeiteinheit,
- $i = 1, ..., N$, ein Index für die Anfangszustände der Trellis,
- $j = 1, ..., N$, ein Index für die Endzustände der Trellis,
- $N$ die Gesamtzahl der Zustände in der Trellis, d.h. die Gesamtzahl der empfangenen elektrischen Signale,

bezeichnet werden.

Die Anfangszustände, denen jeweils eine Zustandsmetrik zugeordnet ist, werden mittels einer Multiplikation mit einer Übergangsmetrik in einen Endzustand

$$S_{\mu,j}, \tag{8}$$

$$S_{\mu,j+\frac{N}{2}}, \tag{9}$$

überführt.

In **Fig.3a** und in **Fig.3b** sind die Zustandsübergänge mit Pfeilen 301, 302, 303, 304 (vgl. **Fig.3a),** 305, 306, 307, 308 (vgl. **Fig.3b**) bezeichnet.

Wird der Viterbi-Algorithmus zum Entzerren des elektrischen Signals eingesetzt, so ergibt sich im einzelnen, wie in [2] gezeigt ist, für die Übergangsmetrik $I_\mu$ :

$$I_\mu = \mathrm{Re}\left\{ \hat{a}_\mu^* \left[ y_\mu - \sum_{l=1}^{L} \hat{a}_{\mu-l}\rho_l \right] \right\}, \qquad (10)$$

mit

$$\hat{a}_\mu \in \{+1,-1\} \qquad (11)$$

als dem geschätzten Übergangssymbol,

$$\hat{a}_{\mu-l} \qquad (12)$$

als dem Zustandssymbol und
$\mu$ als Zeiteinheit.

Die Autokorrelationsfunktion $\rho_l$:

$$\rho_l = \sum_{i=0}^{L-1} h_i^* h_{i+1} \qquad (13)$$

bezieht sich auf die Impulsantwort $h_0,...,h_L$.

$$y_\mu = \sum_{l=0}^{L} e_{\mu+l} h_l^* \qquad (14)$$

ist das Ausgangssignal des auf h(t) bezogenen sogenannten Matched Filters, wobei

$$e_\mu = \sum_{l=0}^{L} a_{\mu-l} h_l \qquad (15)$$

gleich dem empfangenen Signal ist.

Der Term

$$d_i = \sum_{l=1}^{L} \hat{a}_{\mu-1} \rho_l \qquad (16)$$

der Übergangsmetrik wird, wie im weiteren beschrieben, im voraus berechnet und als Referenzmetrik im Speicher, vorzugsweise in einem RAM (**R**andom **A**ccess **M**emory) abgespeichert.

Für ein binäres Symbolalphabet lässt sich folgende Besonderheit ausnutzen. Es ist

$$d_{i+2} - d_i = d_{i+3} - d_{i+1} \qquad (17)$$

für

$$a_\mu \in \{+ 1, -1\}. \qquad (18)$$

Daher muss nicht für jeden Butterfly erneut eine vollständige Zweigmetrik gemäß Vorschrift (10) berechnet werden, sondern es ist ausreichend, die entsprechende Differenz der Referenzmetriken auf die einmal berechnete Übergangsmetrik zu addieren. Die Differenzen der Referenzmetriken werden im voraus berechnet und in einem Speicher abgespeichert.

Im einzelnen ergibt sich folgende Übergangsmetrik für die einzelnen Anfangszustände zu den entsprechenden Endzuständen eines Butterflys in einer Iteration, d.h. für einen Zeitschritt.

Ein erster Anfangszustand $S_{\mu-1,i}$ geht durch Addition mit

$$(-1) \cdot (y - d_i) \qquad (19)$$

in einen ersten Endzustand $S_{\mu,j}$ über.

Der erste Anfangszustand $S_{\mu-1,i}$ geht durch Addition mit

$$(+1) \cdot (y - d_i) \qquad (20)$$

in einen zweiten Endzustand

$$S_{\mu,j+\frac{N}{2}}$$

über.

Weiterhin geht ein zweiter Anfangszustand $S_{\mu-1,i+1}$ durch Addition mit

$$(-1) \cdot (y - d_{i+1}) \qquad (21)$$

in den ersten Endzustand $S_{\mu,j}$ über.

Der zweite Anfangszustand $S_{\mu-1,i+1}$ geht ferner durch Addition mit

$$(+1) \cdot (y - d_{i+1}) \qquad (22)$$

in den zweiten Endzustand

$$S_{\mu,j+\frac{N}{2}}$$

über.

Der gesamte Viterbi-Algorithmus wird derart durchgeführt, dass die Trellis in bekannter Weise für alle berücksichtigten Anfangszustände und Endzustände sowie für alle Zeitschritte, d.h. für die gesamte Länge des elektrischen Signals durchgeführt wird.

Die Decodierung erfolgt in ähnlicher Weise, jedoch mit unterschiedlichen Übergangsmetriken, so dass in dem Betriebsmodus zum Decodieren der erste Anfangszustand $S_{\mu-1,i}$ durch Subtraktion der Übergangsmetrik d in den ersten Endzustand $S_{\mu,j}$ übergeht.

Weiterhin geht der erste Anfangszustand $S_{\mu-1,i}$ durch Addition der Übergangsmetrik d in den zweiten Endzustand

$$S_{\mu,j+\frac{N}{2}}$$

über.

Der zweite Anfangszustand $S_{\mu-1,i+1}$ geht durch Subtraktion der Übergangsmetrik in den ersten Endzustand $S_{\mu,j}$ über.

Durch Addieren der Übergangsmetrik geht der zweite Anfangszustand $S_{\mu-1,i+1}$ in den zweiten Endzustand

$$S_{\mu,j+\frac{N}{2}}$$

über.

Für jede Iteration wird nach Ermitteln des Endzustands, d.h. der Zustandsmetrik des jeweiligen Endzustands für die beiden jeweils ermittelten Werte der maximale Wert ermittelt und ausgewählt.

Die entsprechende Auswahlentscheidung wird üblicherweise binär gespeichert.

Mittels des sogenannten Back-Tracings wird nach erfolgten "Vorwärtsdurchlauf" der Trellis unter Verwendung der gespeicherten Auswahlentscheidungen die statistisch optimale Symbolfolge ermittelt.

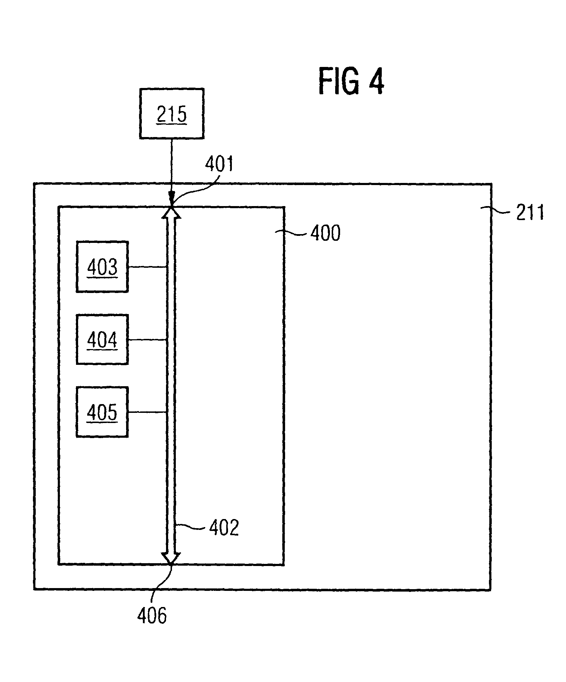

Wie in **Fig.4** gezeigt ist, weist der Empfänger 211 einen digitalen Signalprozessor 400 auf zum Entzerren bzw. zum Kanaldecodieren des elektrischen Signals 215.

Das elektrische Signal 215 wird einem Eingang 401 des digitalen Signalprozessors 400 zugeführt. Der Eingang 401 ist mit einem Signalbus 402 (DSP-Bus) des digitalen Signalprozessors 400 gekoppelt.

Weiterhin ist mit dem Signalbus 402 ein Prozessor 403, ein Speicher 404 sowie eine im Weiteren beschriebene Vorrichtung zum Durchführen des Viterbi-Algorithmus 405 (implementiert als elektrische Schaltung) vorgesehen.

Im Rahmen des Viterbi-Algorithmus werden von dem Prozessor 403 die erforderlichen Zustandsmetriken in die entsprechenden Anfangszustand-Register, welche im weiteren beschrieben werden, der Vorrichtung für den Viterbi-Algorithmus 405 zugeführt bzw. aus den Endzustand-Registern ausgelesen, d.h. die einzelnen Iterationen für die entsprechenden Butterflys im Rahmen des Viterbi-Algorithmus werden durch den Prozessor 403 gesteuert.

Die Übergangsmetriken sowie eine im weiteren beschrieben Änderungs-Übergangsmetrik werden von dem Prozessor 403 ermittelt und ebenfalls in dem Speicher 404, welcher als RAM ausgestaltet ist, gespeichert.

Die im weiteren beschriebenen Register sind jeweils mit einem Eingang bzw. Ausgang mit dem Signalbus 402 verbunden, so dass der Prozessor 403 auf die entsprechenden erforderlichen Register gemäß dem durchzuführenden Viterbi-Algorithmus zugreifen kann.

Ausgangssignal des digitalen Signalprozessors 400, welches an dessen Ausgang 406 anliegt, ist entweder das entzerrte elektrische Signal oder das kanaldecodierte elektrische Signal, d.h. das rekonstruierte Codewort 218, abhängig von dem ausgewählten Betriebsmodus, d.h. abhängig davon, ob der Viterbi-Algorithmus eingesetzt werden soll zur Kanaldecodierung oder zum Entzerren.

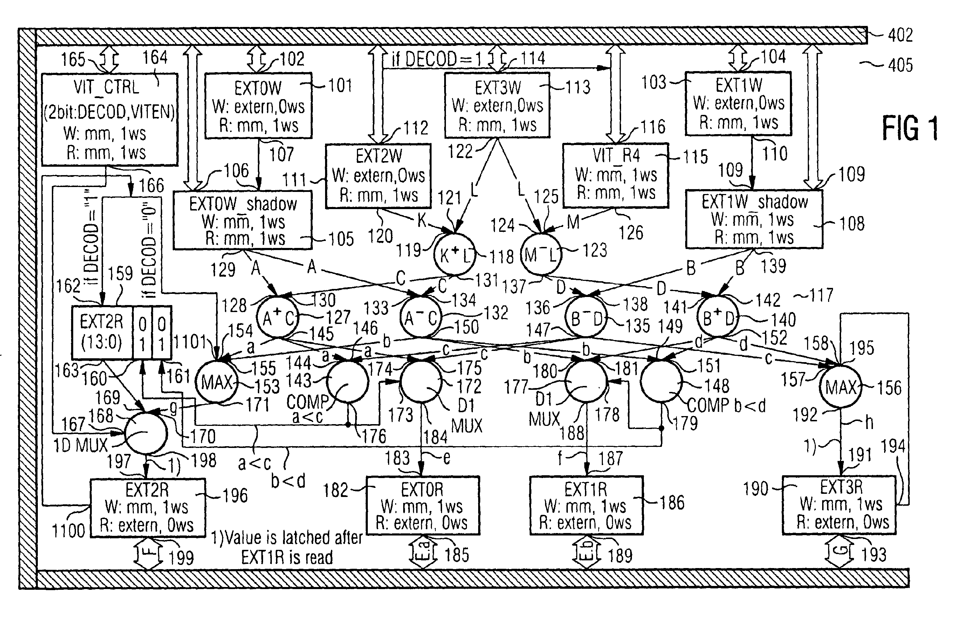

Anhand von **Fig.1** werden die beiden unterschiedlichen Betriebsmodi und deren Auswahl gemäß dem Ausführungsbeispiel der Erfindung für den Viterbi-Algorithmus näher erläutert.

Die Vorrichtung zum Durchführen des Viterbi-Algorithmus, insbesondere zum Implementieren einer Butterfly-Struktur mittels einer elektrischen Schaltung weist folgende Komponenten auf:

Ein erstes Anfangszustands-Register 101, dessen Eingang 102 mit dem Signalbus 402 gekoppelt ist.

Ein zweites Anfangszustands-Register 103, dessen Eingang 104 mit dem Signalbus 402 gekoppelt ist.

Ein erstes Pufferregister 105, dessen Eingang 106 sowohl mit dem Ausgang 107 des ersten Anfangszustands-Registers 101 als auch mit dem Signalbus 402 gekoppelt ist.

Ein zweites Pufferregister 108, dessen Eingang 109 sowohl mit dem Ausgang 110 des zweiten Anfangszustands-Registers 104 als auch mit dem Signalbus 402 gekoppelt ist.

Ein erstes Übergangs-Register 111, dessen Eingang 112 mit dem Signalbus 402 gekoppelt ist.

Ein zweites Übergangs-Register 113, dessen Eingang 114 mit dem Signalbus 402 gekoppelt ist.

Ein drittes Übergangs-Register 115, dessen Eingang 116 mit dem Signalbus 402 gekoppelt ist.

Ein Addier-/Subtrahiernetzwerk 117 weist folgende Komponenten auf:

- Einen ersten Addierer 118, dessen erster Eingang 119 mit dem Ausgang 120 des ersten Übergangs-Registers 111 gekoppelt ist und dessen zweiter Eingang 121 mit dem Ausgang 122 des zweiten Übergangs-Registers 113 gekoppelt ist; durch den ersten Addierer 118 wird die Summe des Werts K in dem ersten Übergangs-Register 111 und des Werts L in dem zweiten Übergangs-Register 113 gebildet;

- einen ersten Subtrahierer 123, dessen erster Eingang 124 mit dem Ausgang 122 des zweiten Übergangs-Registers 113 und dessen zweiter Eingang 125 mit dem Ausgang 126 des dritten Übergangs-Registers 115 gekoppelt ist; durch den ersten Subtrahierer 123 wird die Differenz zwischen dem Wert M in dem dritten Übergangs-Register 115 und dem Wert L in dem zweiten Übergangs-Register 113 gebildet;

- einen zweiten Addierer 127, dessen erster Eingang 128 mit dem Ausgang 129 des ersten Pufferregisters 105 gekoppelt ist und dessen zweiter Eingang 130 mit dem Ausgang 131 des ersten Addierers 118 gekoppelt ist; durch den zweiten Addierer 127 wird die Summe des Werts A in dem ersten Pufferregister 105 und der von dem ersten Addierer 118 gebildeten Summe C gebildet;

- einen zweiten Subtrahierer 132, dessen erster Eingang 133 mit dem Ausgang 129 des ersten Pufferregisters 105 gekoppelt ist und dessen zweiter Eingang 134 mit dem Ausgang 131 des ersten Addierers 118 gekoppelt ist; durch den zweiten Subtrahierer 132 wird die Differenz zwischen dem Wert A in dem ersten Pufferregister 105 und der von dem ersten Addierer 118 gebildeten Summe C gebildet;

- einen dritten Subtrahierer 135, dessen erster Eingang 136 mit dem Ausgang 137 des ersten Subtrahierers 123 gekoppelt ist und dessen zweiter Eingang 138 mit dem Ausgang 139 des zweiten Pufferregisters 108 gekoppelt ist; durch den dritten Subtrahierer 135 wird die Differenz zwischen dem Wert B in dem zweiten Pufferregister 105 und der von dem ersten Subtrahierer 123 gebildeten Differenz D gebildet;

- einen dritten Addierer 140, dessen erster Eingang 141 mit dem Ausgang 137 des ersten Subtrahierers 123 gekoppelt ist und dessen zweiter Eingang 142 mit dem Ausgang 139 des zweiten Pufferregisters 108 gekoppelt ist; durch den dritten Addierer 140 wird die Summe aus der von dem ersten Subtrahierer 123 gebildeten Differenz D und dem Wert B in dem zweiten Pufferregister 108 gebildet;

Weiterhin ist eine erste Vergleichseinheit (Komparator) 143 vorgesehen, deren erster Eingang 144 mit dem Ausgang 145 des zweiten Addierers 127 gekoppelt ist und dessen zweiter Eingang 146 mit dem Ausgang 147 des dritten Subtrahierers 135 gekoppelt ist. Durch die erste Vergleichseinheit 143 wird ermittelt, ob die von dem zweiten Addierer 127 gebildete Summe a kleiner ist als die von dem zweiten Subtrahierer 135 gebildete Differenz c. Ist dies der Fall, so erzeugt die erste Vergleichseinheit 143 ein erstes Vergleichssignal mit einem ersten binären Wert (logisch "1"), sonst mit einem zweiten binären Wert (logisch "0").

Weiterhin ist eine zweite Vergleichseinheit 148 vorgesehen, deren erster Eingang 149 mit dem Ausgang 150 des zweiten Subtrahierers 132 gekoppelt ist und dessen zweiter Eingang 151 mit dem Ausgang 152 des dritten Addierers 140 gekoppelt ist. Durch die zweite Vergleichseinheit 148 wird ermittelt, ob die von dem zweiten Subtrahierer 132 gebildete Differenz b kleiner ist als die von dem dritten Addierer 140 gebildete Summe d. Ist dies der Fall, so erzeugt die zweite Vergleichseinheit 148 ein zweites Vergleichssignal mit einem ersten binären Wert (logisch "1"), sonst mit einem zweiten binären Wert (logisch "0").

Weiterhin ist eine erste Maximum-Auswahleinheit 153 vorgesehen, deren erster Dateneingang 154 mit dem Ausgang 145 des zweiten Addierers 127 gekoppelt ist und dessen zweiter Dateneingang 155 mit dem Ausgang 150 des zweiten Subtrahierers 132 gekoppelt ist. Durch die erste Maximum-Auswahleinheit 153 wird bei deren Aktivierung über deren Steuereingang der größere Wert aus der von dem zweiten Addierer 127 gebildeten Summe a und der von dem zweiten Subtrahierer 132 gebildeten Differenz b ausgewählt und als erstes Maximum-Ausgangssignal g ausgegeben.

Ein erster Dateneingang 157 einer zweiten Maximum-Auswahleinheit 156 ist mit dem Ausgang 147 des dritten Subtrahierers 135 gekoppelt und ein zweiter Dateneingang 158 der zweiten Maximum-Auswahleinheit 156 ist mit dem Ausgang 152 des dritten Addierers 140 gekoppelt. Durch die zweite Maximum-Auswahleinheit 156 wird bei deren Aktivierung über deren Steuereingang der größere Wert aus der von dem dritten Subtrahierer 135 gebildeten Differenz c und der von dem dritten Addierer 140 gebildeten Summe d ausgewählt und als zweites Maximum-Ausgangssignal h ausgegeben.

Weiterhin ist ein Trace-Back-Register 159 vorgesehen, mit einem ersten Dateneingang 160, einem zweiten Dateneingang 161, einem Steuereingang 162 sowie mit einem Datenausgang 163.

Weiterhin ist ein Auswahlregister 164 vorgesehen, dessen Eingang 165 mit dem Signalbus 402 gekoppelt ist. Der Ausgang 166 des Auswahlregisters 164 ist mit einem Steuereingang 167 eines ersten Multiplexers 168 gekoppelt.

Ein erster Eingang 169 des ersten Multiplexers 168 ist mit dem Datenausgang 163 des Trace-Back-Registers 159 gekoppelt und ein zweiter Eingang 170 des ersten Multiplexers 168 ist mit dem Ausgang 171 der ersten Maximum-Auswahleinheit 153 gekoppelt.

Von dem ersten Multiplexer 168 wird, abhängig von dem Inhalt des Auswahlregisters 164, entweder der Inhalt des Trace-Back-Registers 159 (wenn der Betriebsmodus "Decodieren" ausgewählt ist mittels des Auswahlregisters 164) oder das erste Maximum-Ausgangssignal g (wenn der Betriebsmodus "Entzerren" ausgewählt ist mittels des Auswahlregisters 164), ausgewählt.

Weiterhin ist ein zweiter Multiplexer 172 vorgesehen, dessen Steuereingang 173 mit dem ersten Dateneingang 160 des Trace-Back-Registers 159 gekoppelt ist und dessen erster Dateneingang 174 mit dem Ausgang 145 des zweiten Addierers 127 gekoppelt ist und dessen zweiter Dateneingang 175 mit dem Ausgang 147 des dritten Subtrahierers 135 gekoppelt ist.

Der Steuereingang 173 des zweiten Multiplexers 172 ist ferner mit dem Ausgang 176 der ersten Vergleichseinheit 143 gekoppelt.

Gemäß diesem Ausführungsbeispiel wird somit das erste Vergleichssignal, welches in dem Trace-Back-Register 159 gespeichert wird, als Steuersignal für den zweiten Multiplexer 172 verwendet derart, dass für den Fall, dass die von dem zweiten Addierer 127 gebildete Summe a kleiner ist als die von dem zweiten Subtrahierer 135 gebildete Differenz c, die an dem zweiten Eingang 175 des zweiten Multiplexers 172 anliegende Differenz c ausgewählt wird. Ist die von dem zweiten Addierer 127 gebildete Summe a, die an dem ersten Eingang 174 des zweiten Multiplexers 172 anliegt, größer ist als die von dem zweiten Subtrahierer 135 gebildete Differenz c, so wird die Summe a ausgewählt als erstes Endzustandssignal e.

Weiterhin ist ein dritter Multiplexer 177 vorgesehen, dessen Steuereingang 178 mit dem Ausgang 179 der zweiten Vergleichseinheit 148 gekoppelt ist.

Der Ausgang 179 der zweiten Vergleichseinheit 148 ist ferner mit dem zweiten Dateneingang 161 des Trace-Back-Registers 159 gekoppelt.

Ein erster Eingang 180 des dritten Multiplexers 177 ist mit dem Ausgang 150 des zweiten Subtrahierers 132 gekoppelt und ein zweiter Eingang 181 des dritten Multiplexers 177 ist mit dem Ausgang 152 des dritten Addierers 140 gekoppelt.

Gemäß diesem Ausführungsbeispiel wird somit das zweite Vergleichssignal, welches in dem Trace-Back-Register 159 gespeichert wird, als Steuersignal für den dritten Multiplexer 177 verwendet derart, dass für den Fall, dass die von dem zweiten Subtrahierer 132 gebildete Differenz b kleiner ist als die von dem dritten Addierer 140 gebildete Summe d, die an dem zweiten Eingang 181 des dritten Multiplexers 177 anliegende Summe d ausgewählt wird. Ist die von dem zweiten Subtrahierer 132 gebildete Differenz b, die an dem ersten Eingang 180 des dritten Multiplexers 177 anliegt, größer ist als die von dem dritten Addierer 140 gebildete Summe d, so wird die Differenz b ausgewählt als zweites Endzustandssignal f.

Weiterhin ist ein erstes Ausgangszustands-Register 182 vorgesehen, dessen Eingang 183 mit dem Ausgang 184 des zweiten Multiplexers 172 gekoppelt ist. Der Ausgang 185 des ersten Ausgangszustands-Registers 183 ist mit dem Signalbus 402 gekoppelt. In dem ersten Ausgangszustands-Register 182 wird das erste Endzustandssignal e gespeichert.

Weiterhin ist ein zweites Ausgangszustands-Register 186 vorgesehen, dessen Eingang 187 mit dem Ausgang 188 des dritten Multiplexers 177 gekoppelt ist und dessen Ausgang 189 mit dem Signalbus 402 gekoppelt ist. In dem zweiten Ausgangszustands-Register 186 wird das zweite Endzustandssignal f gespeichert.

Ein drittes Ausgangszustands-Register 190 ist über dessen Eingang 191 mit dem Ausgang 192 der zweiten Maximum-Auswahleinheit 156 gekoppelt und dessen Ausgang 193 ist mit dem Signalbus 402 gekoppelt. In dem dritten Ausgangszustands-Register 190 wird das zweite Maximum-Ausgangssignal h gespeichert. Weiterhin ist ein Steuerausgang 194 des dritten Ausgangszustands-Registers 190 mit einem Steuereingang 195 der zweiten Maximum-Auswahleinheit 156 gekoppelt.

Ein viertes Ausgangszustands-Register 196 ist mit dessen Eingang 197 mit dem Ausgang 198 des ersten Multiplexers 170 gekoppelt.

Der Ausgang 199 des vierten Ausgangszustands-Registers 196 ist mit dem Signalbus 402 gekoppelt. Ein Steuerausgang 1100 des vierten Ausgangszustands-Registers 196 ist mit dem Steuereingang des Trace-Back-Registers 162 sowie mit einem Steuereingang 1101 der ersten Maximum-Auswahleinheit 153 gekoppelt.

Im weiteren wird das Ausführen des Viterbi-Algorithmus für das Entzerren eines elektrischen Signals näher erläutert.

In einem ersten Schritt wird die elektrische Schaltung 405 initialisiert und der erste sogenannte Butterfly wird für die Trellis gemäß dem Viterbi-Algorithmus ausgeführt.

Zuerst wird in diesem Zusammenhang die Zustandsmetrik des ersten Anfangszustands $S_{\mu-1,i}$ für die erste Zeiteinheit $\mu-1$ in das erste Anfangszustands-Register 101 geladen.

Die Zustandsmetrik des zweiten Anfangszustands $S_{\mu-1,i+1}$ für die erste Zeiteinheit $\mu-1$ wird in das zweite Anfangszustands-Register 103 geladen.

In einem weiteren Schritt werden das dritte Anfangszustands-Register 192 sowie das vierte Ausgangszustands-Register 198 mit der größten, von dem jeweiligen Register ladbare negative Zahl initialisiert (Maximum-Suche für den besten Nullpfad und für den besten sogenannten Einspfad, wie in [2] beschrieben).

Weiterhin wird das zweite Übergangs-Register 113 mit dem Wert 0 initialisiert.

Der Wert $d_0 - y$ wird in das erste Übergangs-Register 111 geladen und der Wert $y - d_1$ wird in das dritte Übergangs-Register 115 geladen.

In einem weiteren Schritt wird der Wert des zweiten Ausgangszustand-Registers 186 ausgelesen, womit die Werte aus dem ersten Anfangszustand-Register 101 und dem zweiten Anfangszustand-Register 103 in die entsprechenden Pufferregister, d.h. in das erste Pufferregister 105 und in das zweite Pufferregister 108 übernommen werden.

Außerdem werden die am dem ersten Ausgangszustands-Register 182, dem vierten Ausgangszustand-Register 196 und dem dritten Ausgangszustands-Register 190 anliegende Werte über den Signalbus 402 ausgelesen.

Durch das Laden der Pufferregister beginnt die elektrische Schaltung 405 mit dem Berechnen der beiden Folgezustände der Butterfly-Struktur 300, d.h. mit dem Berechnen des ersten Folgezustands und des zweiten Folgezustands sowie der Berechnung der aktuellen Nullpfade und Einspfade. Während dieser Zeit werden die Eingangszustands-Register 101, 103 mit den neuen Werten für den nächsten Butterfly geladen, d.h. vorbelegt.

Nach dem Initialisieren und dem ersten Butterfly ist der Ablauf für die folgenden iterativ durchgeführten Butterflys innerhalb eines Zeitschrittes $\mu$ identisch und wird für alle berücksichtigten Zustände innerhalb der Trellis gemäß dem Viterbi-Algorithmus durchgeführt :

Die Zustandsmetrik des jeweiligen Anfangszustands $S_{\mu-1,i}$, wird in das erste Anfangszustands-Register 101 geladen. Die Zustandsmetrik des zweiten Anfangszustands $S_{\mu-1,i+1}$ wird in das zweite Anfangszustands-Register 103 geladen.

Anschließend wird ein Wert in das zweite Übergangs-Register 113 geladen, wobei der Wert sich gemäß folgender Vorschrift ergibt:

$$d_{i+2} - d_i = d_{i+3} - d_{i+1.} \tag{17}$$

Wenn sichergestellt ist, dass die von dem Addier/Subtrahiernetzwerk 117 und den entsprechenden Multiplexern, Vergleichseinheiten bzw. dem Trace-Back-Register und den Maximum-Auswahleinheiten ermittelten Werte stabil anliegen, dann werden die durch die Rechenschritte in dem Endzustands-Register gespeicherten Ergebnisse für die Folgezustände, d.h. Endzustände $S_{\mu,j}$ und

$$S_{\mu,j+\frac{N}{2}}$$

aus dem ersten Endzustands-Register 182 und dem zweiten Endzustands-Register 186 über den Signalbus 402 ausgelesen, wobei gleichzeitig mit dem Lesen des zweiten Endzustands-Registers 186 das Berechnen der Werte für den nächsten Butterfly gestartet wird, wie oben beschrieben wurde.

Es ist anzumerken, dass im Rahmen der Entzerrung das Trace-Back-Register 159 nicht erforderlich ist, d.h., das über den ersten Multiplexer 170 lediglich Elemente der ersten Maximum-Auswahleinheit 153 in das vierte Endzustand-Register 198 gespeichert werden können.

Wenn der letzte Butterfly für die Trellis für den jeweiligen Zeitschritt ermittelt worden ist, dann werden aus dem dritten Endzustands-Register 190 und dem vierten Endzustands-Register 190 der beste Nullpfad bzw. Einspfad gelesen.

Bei der Kanaldecodierung eines kanalcodierten Codeworts mit einem binären Symbolalphabet gilt der in **Fig. 3b** dargestellte Butterfly 310, wobei die Zweigmetrik d jeweils die Summe von Zuverlässigkeitswerten, geliefert von dem Entzerrer, deren Anzahl sich aus der Rate des Faltungscodes ergibt.

Die Zuverlässigkeitswerte werden, wie oben beschrieben wurde, vor dem Aufsummieren mit einem Vorzeichen belegt, das sich aus dem Trelliszustand und dem Polynom des Faltungscodes ergibt.

Es ist anzumerken, dass durch die elektrische Schaltung 405 eine Maximum-Likelihood-Sequence Estimation (MLSE) implementiert ist, d.h. es wird zunächst die vollständige Empfangsfolge der elektrischen Signale in dem Trellisdiagramm abgearbeitet, wobei die jeweiligen ausgewählten Endzustände abgespeichert werden in dem Trace-Back-Register und anschließend wird mittels des sogenannten Back Tracing die Ausgabe der geschätzten statistisch optimalen Signalfolge ermittelt.

Die elektrische Schaltung 405 berechnet die Endzustände gemäß dem Butterfly aus **Fig.3b** und speichert zusätzlich für das Back Tracing die entsprechenden Auswahlentscheidungen in dem jeweiligen Zeitschritt μ.

Im Rahmen der Kanaldecodierung wird die elektrische Schaltung 405 auf folgende Weise initialisiert und es wird auf folgende Weise ein erster Butterfly ausgeführt:

Das zweite Übergangs-Register 113 wird mit dem Wert 0 vorbelegt.

In einem weiteren Schritt wird die Zustandsmetrik des ersten Anfangszustands in das erste Anfangszustands-Register 101 geladen. Weiterhin wird der zweite Anfangszustand, d.h. die Zustandsmetrik des zweiten Anfangszustands in das zweite Anfangszustands-Register 103 geladen.

Weiterhin wird die Übergangsmetrik in das erste Übergangs-Register 111 geladen.

Das zweite Endzustands-Register 188 wird ausgelesen, wodurch das Laden der in dem ersten Anfangszustands-Register 101 und dem zweiten Anfangszustands-Register 103 geladenen Werte in die entsprechenden Pufferregister, d.h. in das erste Pufferregister 105 und in das zweite Pufferregister 108 initiiert wird. Damit beginnen die Berechnungen des Butterflys.

Während die elektrische Schaltung 405 die Endzustände berechnet, können die Zustandsmetriken für den nächsten Butterfly in das erste Anfangszustands-Register 101 und das zweite Anfangszustands-Register 103 geschrieben werden.

Für die weiteren Iterationen für die folgenden Butterflys ergibt sich demnach folgende Vorgehensweise:

Die Zustandsmetrik des jeweils ersten Anfangszustands $S_{\mu-1,i}$ wird in das erste Anfangszustand-Register 101 geladen. Weiterhin wird die Zustandsmetrik des zweiten Anfangszustands $S_{\mu-1,i+1}$ in das zweite Anfangszustand-Register 103 geladen.

Wenn sichergestellt ist, dass die in den Registern gespeicherten Daten stabil anliegen, dann werden die Endzustände aus den Endzustands-Registern, d.h. insbesondere aus dem ersten Endzustand-Register 182 und dem zweiten Endzustands-Register 186 gelesen, wodurch, wie oben beschrieben worden ist, das Berechnen der nächsten Iteration für den nächsten Butterfly unmittelbar gestartet wird.

Für jeden Endzustand wird die Auswahlentscheidung in das vierte Endzustands-Register 196 in Form eines Bits geschrieben. Daher muss nach spätestens acht Butterflys bei einer Breite von 8 Bit des vierten Endzustand-Registers 198 das Trace-Back-Register, welches eine Länge von 3 Bit aufweist, gelesen werden.

Das vierte Endzustands-Register 196 wird ebenfalls mit dem Lesen des zweiten Endzustands-Registers 198 aktualisiert.

In diesem Dokument sind folgende Veröffentlichungen zitiert:

[1] WO 99/34520

[2] W. Koch und A. Baier, Optimum and Suboptimum Detection of Coded Data Disturbed by Time-Varying Intersymbol Interference, IEEE GLOBECOM, S. 1679 - 1684, 1999

[3] G.D. Forney, The Viterbi-Algorithm, Proceedings of the IEEE , Vol. 61, No. 3, S. 268 - 278, 1973

**Patentansprüche**

1. Vorrichtung zum Durchführen eines Viterbi-Algorithmus,

- mit mehreren Anfangszustand-Registern, in die jeweils eine Zustandsmetrik eines Anfangszustands einer Trellis speicherbar ist,
- mit mindestens einem Übergang-Register, in dem eine Übergangsmetrik der Trellis speicherbar ist,
- mit einem Addier-/Subtrahiernetzwerk, das mit den Anfangszustand-Registern, dem Übergangs-Register und Auswerteeinheiten gemäß einer Butterfly-Struktur der Trellis verbunden sind,
- mit mehreren Auswerteeinheiten, in denen die von dem Addier-/Subtrahiernetzwerk verarbeiteten Signale gemäß dem Viterbi-Algorithmus ausgewertet werden,
- mit einer Auswahleinheit, in der zwischen einem ersten Betriebsmodus und einem zweiten Betriebsmodus der Vorrichtung umgeschaltet werden kann,
- mit mehreren mit den Auswerteeinheiten gekoppelten Endzustand-Registern, in die jeweils eine Zustandsmetrik eines jeweiligen Endzustands der Trellis speicherbar ist, und
- bei der mit der Auswahleinheit unterschiedliche Auswerteeinheiten auswählbar sind abhängig von dem gewählten Betriebsmodus.

2. Vorrichtung nach Anspruch 1,
bei der mindestens eines der Anfangszustand-Register zusätzlich ein Pufferregister aufweist.

3. Vorrichtung nach Anspruch 1 oder 2,
bei der mindestens ein Übergangs-Register zum Speichern einer Übergangsmetrik, wenn die Vorrichtung in den ersten Betriebsmodus geschaltet ist, und/oder zum Speichern einer Änderungs-Übergangsmetrik, wenn die Vorrichtung in den zweiten Betriebsmodus geschaltet ist, aufweist.

4. Vorrichtung nach einem der Ansprüche 1 bis 3,
bei der mindestens zwei Übergangs-Register zum Speichern zweier unterschiedlicher Übergangsmetriken aufweist, wenn die Vorrichtung in den zweiten Betriebsmodus geschaltet ist.

5. Vorrichtung nach einem der Ansprüche 1 bis 4,
mit einem Prozessor, der mit den Registern mittels eines Signalbus gekoppelt ist.

6. Vorrichtung nach Anspruch 5,
bei der der Prozessor zum Berechnen der Metriken ausgestaltet ist.

7. Vorrichtung nach einem der Ansprüche 1 bis 6,
mit einem Speicher, der mit den Registern mittels eines Signalbus gekoppelt ist und in den die Metriken speicherbar sind.

8. Vorrichtung nach einem der Ansprüche 1 bis 7,
bei der das Addier-/Subtrahiernetzwerk mindestens einen Addierer und/oder mindestens einen Subtrahierer aufweist.

9. Vorrichtung nach Anspruch 2 und 8,
bei der das Addier-/Subtrahiernetzwerk drei Addierer und drei Subtrahierer aufweist, wobei

- ein erster Eingang eines ersten Addierers mit dem Ausgang eines ersten Übergang-Registers gekoppelt ist,
- ein zweiter Eingang des ersten Addierers mit dem Ausgang eines zweiten Übergang-Registers gekoppelt ist,
- ein erster Eingang eines ersten Subtrahierers mit dem Ausgang des zweiten Übergang-Registers gekoppelt ist,
- ein zweiter Eingang des ersten Subtrahierers mit dem Ausgang eines dritten Übergang-Registers gekoppelt ist,
- ein erster Eingang eines zweiten Addierers mit dem Ausgang eines ersten Pufferregisters gekoppelt ist,
- ein zweiter Eingang des zweiten Addierers mit dem Ausgang des ersten Addierers gekoppelt ist,
- ein erster Eingang eines zweiten Subtrahierers mit dem Ausgang des ersten Pufferregisters gekoppelt ist,
- ein zweiter Eingang des zweiten Subtrahierers mit dem Ausgang des ersten Addierers gekoppelt ist,
- ein erster Eingang eines dritten Addierers mit dem Ausgang des ersten Subtrahierers gekoppelt ist,
- ein zweiter Eingang des dritten Addierers mit dem Ausgang eines zweiten Pufferregisters gekoppelt ist,
- ein erster Eingang eines dritten Subtrahierers mit dem Ausgang des ersten Subtrahierers gekoppelt ist,
- ein zweiter Eingang des dritten Subtrahierers mit dem Ausgang des zweiten Pufferregisters gekoppelt ist.

10. Vorrichtung nach einem der Ansprüche 1 bis 9,
bei der die Auswerteeinheiten

- Trace-Back-Register, und/oder
- Vergleichseinheiten, und/oder
- Maximum-Auswahlelemente aufweisen.

11. Vorrichtung nach Anspruch 10,

- bei der ein Steuereingang eines Trace-Back-Registers mit einem Steuerausgang eines ersten Endzustand-Registers gekoppelt ist derart, dass bei Auslesen eines Werts aus dem ersten Endzustand-Register das Trace-Back-Register neue Werte speichern kann,
- bei der ein erster Dateneingang des Trace-Back-Registers mit dem Ausgang eines ersten Vergleichers gekoppelt ist, und
- bei der ein zweiter Dateneingang des Trace-Back-Registers mit dem Ausgang eines zweiten Vergleichers gekoppelt ist.

**12.** Vorrichtung nach Anspruch 10 oder 11,

- bei der ein erster Eingang eines ersten Vergleichers mit dem Ausgang des zweiten Addierers gekoppelt ist,
- bei der ein zweiter Eingang des ersten Vergleichers mit dem Ausgang des dritten Subtrahierers gekoppelt ist,
- bei der ein erster Eingang eines zweiten Vergleichers mit dem Ausgang des zweiten Subtrahierers gekoppelt ist,
- bei der ein zweiter Eingang des zweiten Vergleichers mit dem Ausgang des dritten Addierers gekoppelt ist.

**13.** Vorrichtung nach einem der Ansprüche 10 bis 12,

- bei der ein Steuereingang eines ersten Maximum-Auswahlelements mit dem Steuerausgang des ersten Endzustand-Registers gekoppelt ist derart, dass bei Auslesen eines Werts aus dem ersten Endzustand-Register das Maximum-Auswahlelements einen neuen Wert auswählen kann,
- bei der ein erster Eingang des ersten Maximum-Auswahlelements mit dem Ausgang des zweiten Addierers gekoppelt ist,
- bei der ein zweiter Eingang des ersten Maximum-Auswahlelements mit dem Ausgang des zweiten Subtrahierers gekoppelt ist,
- bei der ein Steuereingang eines zweiten Maximum-Auswahlelements mit einem Steuerausgang eines zweiten Endzustand-Registers gekoppelt ist derart, dass bei Auslesen eines Werts aus dem zweiten Endzustand-Register das Maximum-Auswahlelements einen neuen Wert auswählen kann,
- bei der ein erster Eingang des zweiten Maximum-Auswahlelements mit dem Ausgang des dritten Subtrahierers gekoppelt ist,
- bei der ein zweiter Eingang des zweiten Maximum-Auswahlelements mit dem Ausgang des dritten Addierers gekoppelt ist.

**14.** Vorrichtung nach einem der Ansprüche 1 bis 13,
bei der die Auswahleinheit

- ein Auswahlregister,
- mindestens einen Multiplexer aufweist.

**15.** Vorrichtung nach Anspruch 14,

- bei der der Eingang des Auswahlregisters mit dem DSP-Bus gekoppelt ist,
- bei der der Ausgang des Auswahlregisters mit einem Steuereingang eines ersten Multiplexers gekoppelt ist,
- bei der ein erster Dateneingang des ersten Multiplexers mit einem ersten Datenausgang des Trace-Back-Registers gekoppelt ist,
- bei der ein zweiter Dateneingang des ersten Multiplexers mit dem Ausgang des ersten Maximum-Auswahlelements gekoppelt ist,
- bei der ein Steuereingang eines zweiten Multiplexers mit einem zweiten Datenausgang des Trace-Back-Registers gekoppelt ist,
- bei der ein erster Dateneingang des zweiten Multiplexers mit dem Ausgang des zweiten Addierers gekoppelt ist,
- bei der ein zweiter Dateneingang des zweiten Multiplexers mit dem Ausgang des dritten Subtrahierers gekoppelt ist,
- bei der ein Steuereingang eines dritten Multiplexers mit einem dritten Datenausgang des Trace-Back-Registers gekoppelt ist,
- bei der ein erster Dateneingang des dritten Multiplexers mit dem Ausgang des zweiten Subtrahierers gekoppelt ist,
- bei der ein zweiter Dateneingang des dritten Multiplexers mit dem Ausgang des dritten Addierers gekoppelt ist.

**16.** Vorrichtung nach einem der Ansprüche 1 bis 15,
bei der der erste Betriebsmodus ein Modus ist, in dem ein Decodieren gemäß dem Viterbi-Algorithmus durchgeführt wird.

**17.** Vorrichtung nach einem der Ansprüche 1 bis 16,
bei der der zweite Betriebsmodus ein Modus ist, in dem ein Entzerren gemäß dem Viterbi-Algorithmus durchgeführt wird.

**18.** Verfahren zum Durchführen eines Viterbi-Algorithmus,

- bei dem ein erster Betriebsmodus oder ein zweiter Betriebsmodus einer Vorrichtung zum Durchführen des Viterbi-Algorithmus ausgewählt wird,
- bei dem jeweils eine Zustandsmetrik eines Anfangszustands einer Trellis in jeweils ein Anfangszustand-Register gespeichert wird,
- bei dem mindestens eine Übergangsmetrik der Trellis gespeichert wird, abhängig von dem ausgewählten Betriebsmodus,
- bei dem die Zustandsmetriken der Anfangszustände und die Übergangsmetrik miteinander gemäß einer Butterfly-Struktur der Trellis miteinander verknüpft werden, gemäß dem Viterbi-Algorithmus, abhängig von dem ausgewählten Betriebsmodus,
- bei dem die verknüpften Größen abhängig von dem ausgewählten Betriebsmodus ausgewählt werden,
- bei dem die ausgewählten verknüpften Größen als Zustandsmetrik eines jeweiligen Endzustands der Trellis gespeichert werden,
- bei dem das Verfahren iterativ durchgeführt wird solange, bis der Viterbi-Algorithmus beendet worden ist.

**19.** Verfahren nach Anspruch 18,
eingesetzt zum Bearbeiten physikalischer Signale.

**20.** Verfahren nach Anspruch 19,

- bei dem in dem ersten Betriebsmodus die physikalischen Signale decodiert werden, und
- bei dem in dem zweiten Betriebsmodus die physikalischen Signale entzerrt werden.

**21.** Verfahren nach einem der Ansprüche 18 bis 20,

- bei dem, sobald ein Endzustand aus einem Endzustand-Register ausgelesen wird, die jeweilige in dem Anfangszustand-Register gespeicherte Zustandsmetrik des Anfangszustands der Trellis in jeweils ein Pufferregister gespeichert wird, und
- bei dem eine neue Zustandsmetrik eines Anfangszustands einer Trellis in jeweils ein Anfangszustand-Register gespeichert wird, sobald der jeweilige Anfangszustand der Trellis in dem Pufferregister gespeichert ist.

FIG 1

EP 1 158 683 A1

# FIG 2

## FIG 3A

$S_{\mu-1,i}$    301    $(-1)(y - d_i)$    $S_{\mu,j}$

302

$(-1)(y - d_{i+1})$

300

303

$(+1)(y - d_i)$

304

$S_{\mu-1,i+1}$    $(+1)(y - d_{i+1})$    $S_{\mu,j+N/2}$

## FIG 3B

305

$S_{\mu-1,i}$    $-d$    $S_{\mu,j}$

306

$-d$

310

307

$+d$

308

$S_{\mu-1,i+1}$    $+d$    $S_{\mu,j+N/2}$

# FIG 4

Europäisches
Patentamt

**EUROPÄISCHER RECHERCHENBERICHT**

Nummer der Anmeldung

EP 00 11 1182

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X<br><br>A | US 5 181 209 A (HAGENAUER JOACHIM ET AL) 19. Januar 1993 (1993-01-19)<br>* Spalte 2, Zeile 33 - Spalte 4, Zeile 22 *<br><br>* Spalte 9, Zeile 48 - Zeile 62; Abbildung 3 *<br>--- | 1,3,5-8, 10,16-21<br>2,4,9, 11-15 | H03M13/45 G11B20/10 |
| A | BAUCH G ET AL: "ITERATIVE EQUALIZATION AND DECODING IN MOBILE COMMUNICATIONS SYSTEMS"<br>PROCEEDINGS OF EUROPEAN PERSONAL AND MOBILE COMMUNICATIONS CONFERENCE, 30. September 1997 (1997-09-30), XP002060630<br>* Absatz [000I]; Abbildungen 1,3 *<br>* Absatz [0III] *<br>--- | 1-21 | |
| D,A | FORNEY G D: "THE VITERBI ALGORITHM"<br>PROCEEDINGS OF THE IEEE,US,IEEE. NEW YORK, Bd. 61, Nr. 3, 1. März 1973 (1973-03-01), Seiten 268-278, XP000573242<br>ISSN: 0018-9219<br>* Absatz [0III]; Abbildung 8 *<br>----- | 1-21 | **RECHERCHIERTE SACHGEBIETE** (Int.Cl.7)<br><br>H04L<br>H03M<br>G11B |

Der vorliegende Recherchenbericht wurde für alle Patentansprüche erstellt

| Recherchenort | Abschlußdatum der Recherche | Prüfer |
|---|---|---|
| DEN HAAG | 16. Oktober 2000 | Georgiou, G |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 00 11 1182

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

16-10-2000

| Im Recherchenbericht angeführtes Patentdokument | Datum der Veröffentlichung | Mitglied(er) der Patentfamilie | Datum der Veröffentlichung |
|---|---|---|---|
| US 5181209 A | 19-01-1993 | DE 3910739 A | 11-10-1990 |
| | | EP 0391354 A | 10-10-1990 |
| | | JP 2288512 A | 28-11-1990 |
| | | JP 2533219 B | 11-09-1996 |

EPO FORM P0461

Für nähere Einzelheiten zu diesem Anhang : siehe Amtsblatt des Europäischen Patentamts, Nr.12/82